# EUROPEAN PATENT APPLICATION

(11) **EP 4 485 532 A1**
(43) Date of publication of application: **01.01.2025**
(21) Application number: 23213496.5
(22) Date of filing: 30.11.2023
(51) Int. Cl.: H01L 27/02, H01L 21/8234, H01L 27/118

(54) **STAGGERED VIA ARCHITECTURE ACROSS UNIT CELLS**

(30) Priority: 26.06.2023 US 202318213963
(71) Applicant: INTEL Corporation, Santa Clara, CA 95054 (US)
(72) Inventor: YEMENICIOGLU, Sukru, Portland, OR 97229 (US); WU, Tai-Hsuan, Portland, OR 97229 (US); RYZHENKO VLADIMIROVICH, Nikolay, Beaverton, OR 97006 (US); KRISHNAMOORTHY, Anand, Portland, OR 97229 (US); TALALAY, Mikhail Sergeevich, Portland, OR 97229 (US); WANG, Xinning, Hillsboro, OR 97124 (US); SHI, Quan, Portland, OR 97229 (US); AKIN, Ozdemir, Beaverton, OR 97007 (US)
(74) Representative: HGF

(57) **Abstract**

Techniques are described for designing and forming cells having transistor devices. In an example, an integrated circuit structure includes a plurality of cells where adjacent cells have a decreased distance between them along their height and a staggered via arrangement. Accordingly, a first cell may be adjacent to a second cell along a shared cell boundary. A first via is provided between a first gate structure of the first cell adjacent to the cell boundary and a first metal layer above the first gate structure, and a second via is provided between a second gate structure of the second cell adjacent to the cell boundary and a second metal layer above the second gate structure. No part of the first via is aligned with any part of the second via along the first direction.

## Description

### FIELD OF THE DISCLOSURE

The present disclosure relates to integrated circuits, and more particularly, to designing and forming cells comprising transistor devices for an integrated circuit.

### BACKGROUND

In designing and forming integrated circuit structures, standard unit cell libraries are developed with a given number of transistors per unit cell. A number of signal tracks may also be used in an interconnect layer about the transistors to make connections to the various transistor elements. As devices and unit cells become smaller, designing the signal tracks to correctly route the various signals becomes increasingly challenging. Accordingly, there remain a number of non-trivial challenges with respect to designing layout of various cells of the integrated circuit structure for improved PPA (power, performance, and area) performance.

### BRIEF DESCRIPTION OF THE DRAWINGS

Figure 1 is a plan view of an integrated circuit structure that includes a plurality of unit cells having an aligned via arrangement, giving rise to wasted or dead space.
Figure 2 is a plan view of an integrated circuit structure that includes a plurality of unit cells having a staggered via arrangement, according to an embodiment of the present disclosure.
Figures 3A - 3G are plan views that illustrate various stages in an example process for forming unit cells with a staggered via arrangement, in accordance with some embodiments of the present disclosure.
Figure 4 illustrates a cross-sectional view of a chip package containing one or more semiconductor dies, in accordance with some embodiments of the present disclosure.
Figure 5 illustrates a flowchart depicting a method of designing and forming the integrated circuit structure of Figure 2, in accordance with an embodiment of the present disclosure.
Figure 6 illustrates a computing system including one or more integrated circuits, as variously described herein, in accordance with an embodiment of the present disclosure.

As will be appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used. Likewise, while the thickness of a given first layer may appear to be similar in thickness to a second layer, in actuality that first layer may be much thinner or thicker than the second layer; same goes for other layer or feature dimensions.

### DETAILED DESCRIPTION

Techniques are described for designing and forming cells comprising transistor devices for an integrated circuit. In an example, an integrated circuit structure includes a plurality of cells where adjacent cells have a decreased distance between them along their height and a staggered via arrangement. In an example, a first cell may be adjacent to a second cell along a shared cell boundary. Also, a first via is provided between a first gate structure of the first cell adjacent to the cell boundary and a first metal layer above the first gate structure, and a second via is provided between a second gate structure of the second cell adjacent to the cell boundary and a second metal layer above the second gate structure. The first and second gate structures each extend along a first direction and the first metal layer and second metal layer each extend along a second direction different than the first direction. No part of the first via is aligned with any part of the second via along the first direction. Numerous configurations and variations will be apparent in light of this disclosure.

### General Overview

As mentioned herein above, there remain a number of non-trivial challenges with respect to designing layout of various cells of integrated circuit structures. For example, only a limited number of signal tracks are available for making connections to the various transistor elements of a given cell. This number is constrained based on the size of the unit cell and the limitations of lithography. As a result, achieving smaller unit cells becomes challenging as signal tracks and vias end up too close together, thus causing parasitic effects that may degrade device performance. Dead space and/or dummy structures may be added to the cell boundaries to reduce these effects. However, these techniques can lead to wasted area and lower PPA (Power, Performance, and Area) of the integrated circuit structure.

Accordingly, techniques are described herein to form integrated circuit structures having adjacent cells using a staggered via arrangement that allows for reduced dead space and/or dummy structures between the cells. Typically, vias used to contact similar features of adjacent cells are aligned along a given cardinal direction (e.g., along the height of the cells). However, according to some embodiments, the vias for corresponding structures of adjacent cells are purposefully staggered apart such that no part of one via overlaps with any part of the other via along the height direction of the cells. Since the vias are further separated from one another, more dead space between the two cells at the cell boundary can be removed and the effective size of the cells can be reduced. The term "via" as used herein may also be used to refer to structures sometimes known as "contacts," which extend between a transistor element and a first metal layer of an interconnect structure.

In some examples, a first cell may be adjacent to a second cell along a first direction with a cell boundary between the two cells. Note that the cell boundary does not refer to a specific structure and instead identifies a delineation between repeating transistor arrangements. Both the first cell and second cell may include the same arrangement of transistor structures, including the same arrangement of gate structures and diffusion region (e.g., source or drain region) contacts. The gate structures of both cells may extend lengthwise along a first direction (e.g., along the height of the cells). Furthermore, both the first cell and second cell may include the same arrangement of signal tracks above the respective cells (e.g., four signal tracks above each cell). Each of the signal tracks may extend lengthwise along a second direction different from the first direction (e.g., perpendicular to the first direction).

According to some embodiments, a first signal track above the first cell is adjacent to a second signal track above the second cell and on either side of the cell boundary between the two cells. A first via extends between the first signal track and a first gate structure of the first cell and a second via extends between the second signal track and a second gate structure of the second cell. Due to the staggered arrangement, no part of the first via overlaps with any part of the second via along the first direction. Other vias coupled to the first and second signal tracks may similarly not be aligned. For example, a third via between the first signal track and a higher third signal track running along the first direction is not aligned to any portion of a fourth via between the second signal track and a higher fourth signal track running along the first direction. By spreading the vias apart in this way, the distance along the first direction between a center of the first via and a center of the second via can be reduced to less than 40 nm. In some embodiments, this distance between the centers of the first and second vias is between about 16 nm and about 36 nm. In some examples, the distance along the second direction between the center of the first via and the center of the second via is between about 34 nm and about 50 nm. Other embodiments may have different geometries.

According to some embodiments, an integrated circuit structure includes a first cell having two or more first transistor devices with the two or more first transistor devices comprising a first gate structure extending along a first direction within the first cell and a second cell adj acent to the first cell in the first direction. The second cell has two or more second transistor devices with the two or more second transistor devices comprising a second gate structure extending along the first direction within the second cell. The integrated circuit structure further includes a first metal layer extending along a second direction different from the first direction and above the first gate structure, a second metal layer extending along the second direction and above the second gate structure, a first via extending in a third direction between the first metal layer and the underlying first gate structure, and a second via extending in the third direction between the second metal layer and the underlying second gate structure. No part of the second via overlaps with any part of the first via along the first direction.

According to some embodiments, an integrated circuit designing system includes at least one processor, a non-transitory storage medium storing instructions that, when executed by the at least one processor, cause the system to perform a method. The method includes accessing a cell library having unit cells, wherein each unit cell has corresponding two or more transistor devices, receiving data about a circuit to be implemented using the unit cells, designing an array containing rows and columns of unit cells to implement the circuit, and designing a plurality of interconnect structures to implement the circuit. A column of unit cells includes a first unit cell and a second unit cell directly adjacent to the first unit cell. The first unit cell comprises a first gate structure extending along a first direction within the first unit cell and the second unit cell comprises a second gate structure extending along the first direction within the second unit cell. The plurality of interconnect structures include a first metal layer extending along a second direction different from the first direction and above the first gate structure, a second metal layer extending along the second direction and above the second gate structure, a first via extending in a third direction between the first metal layer and the underlying first gate structure, and a second via extending in the third direction between the second metal layer and the underlying second gate structure. No part of the second via overlaps with any part of the first via along the first direction.

According to some embodiments, an integrated circuit structure includes a first transistor device, a second transistor device, a first via, and a second via. The first transistor device includes a first source region, a first drain region, a first body comprising semiconductor material extending from the first source region to the first drain region in a first direction, and a first gate structure extending over the first body in a second direction different from the first direction. The second transistor device is spaced from the first transistor device along the first direction and along the second direction. The second transistor device includes a second source region, a second drain region, a second body comprising semiconductor material extending from the second source region to the second drain region in the first direction, and a second gate structure extending over the second body in the second direction. The first via is coupled to the first gate structure and extends in a third direction above the first gate structure. The second via is couped to the second gate structure and extends in a third direction above the second gate structure. A distance between a center of the first via and a center of the second via along the second direction is less than 40 nm.

According to some embodiments, an integrated circuit structure includes a first cell having two or more first transistor devices with the two or more first transistor devices comprising a first gate structure extending along a first direction within the first cell and a first contact on a first source or drain region adjacent to the first gate structure, and a second cell adjacent to the first cell in the first direction. The second cell has two or more second transistor devices with the two or more second transistor devices comprising a second gate structure extending along the first direction within the second cell and a second contact on a second source or drain region adjacent to the second gate structure. The integrated circuit structure further includes a first metal layer extending along a second direction different from the first direction and above the first contact, a second metal layer extending along the second direction and above the second contact, a first via extending in a third direction between the first metal layer and the underlying first contact, and a second via extending in the third direction between the second metal layer and the underlying second contact. No part of the second via overlaps with any part of the first via along the first direction.

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

It should be readily understood that the meaning of "above" and "over" in the present disclosure should be interpreted in the broadest manner such that "above" and "over" not only mean "directly on" something but also include the meaning of over something with an intermediate feature or a layer therebetween. As used herein, the term "backside" generally refers to the area beneath one or more semiconductor devices (below the device layer) either within the device substrate or in the region of the device substrate (in the case where the bulk of the device substrate has been removed). Note that the backside may become a frontside, and vice-versa, if a given structure is flipped. To this end, and as will be appreciated, the use of terms like "above" "below" "beneath" "upper" "lower" "top" and "bottom" are used to facilitate discussion and are not intended to implicate a rigid structure or fixed orientation; rather such terms merely indicate spatial relationships when the structure is in a given orientation.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. The phrase "substantially" is used herein, and for purposes of this disclosure, "A" is substantially equal to "B" implies that A and B differ by at most 1 nm or 2 nm (e.g., A is within 1 or 2 nm of B).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For example, in some embodiments, such tools may be used to detect an integrated circuit structure comprising adjacent cells with vias along the cell boundary between the adjacent cells that do not overlap along the direction of the cell height. For instance, in some examples, in the block level, abutted cells will not have aligned diffusion (source or drain) contact vias, gate contact vias, and metal M0 contact vias across the top or bottom cell border. In some examples, the first vertical metal routing track M1 will go out of the cell that it originates from and enter into the neighboring cell along the height direction of the cell. Numerous configurations and variations will be apparent in light of this disclosure.

### Architecture

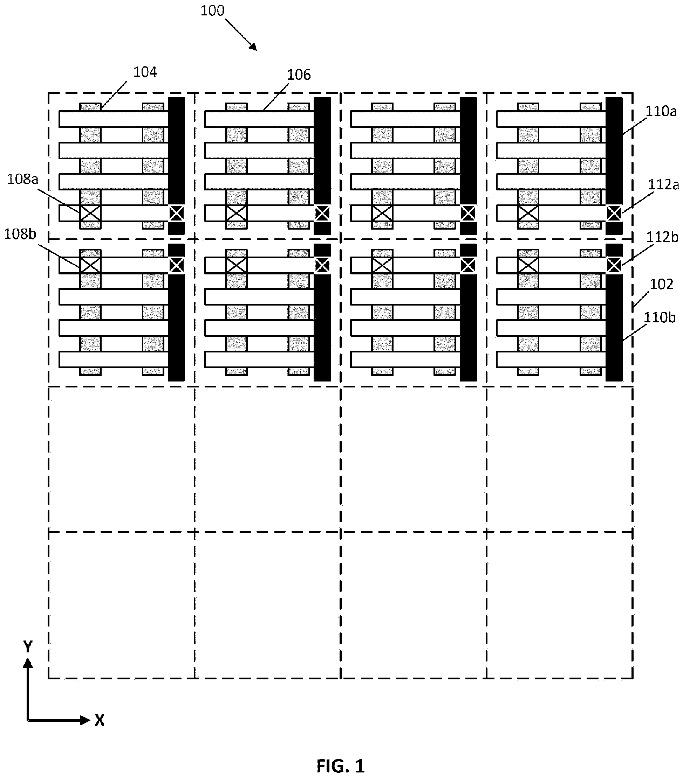

Figure 1 is a plan view of an integrated circuit structure 100 that includes a plurality of cells 102, wherein each cell 102 has a substantially similar height along the Y direction and width along the X direction. The cells are arranged adjacent to one another in an array of rows and columns with cell boundaries identified by dashed lines. Each cell contains the same arrangement of transistors structures. Some of these structures are illustrated for only the top two rows of cells for clarity. Accordingly, each cell includes at least two transistor devices. For example, a given cell has two or more parallel gate structures 104 that run lengthwise along the height of the cell (e.g., along the Y-direction), and signal tracks 106 that run lengthwise along the width of the cell (e.g., along the X-direction).

Vias are formed between signal tracks 106 and gate structures 104 to route signals to and from the transistor gates. A first via 108a from a first cell is formed between a corresponding signal track 106 and gate structure 104 of the first cell and a second via 108b from a second cell is formed between a corresponding signal track 106 and gate structure 104 of the second cell. Because first via 108a and second via 108b are aligned with one another along the Y-direction, they must be separated by a certain amount of space along the Y-direction to minimize parasitic capacitance between them. However, this then creates dead space between cells along the Y-direction and on either side of the cell boundaries between adjacent cells along the Y-direction. Other vias and/or metal layers may also cause a similar problem. For example, a first metal layer 110a from a higher interconnect level above the first cell may be coupled to a given signal line 106 through a third via 112a of the first cell while a second metal layer 110b from a higher interconnect level above the second cell may be coupled to a given signal line 106 through a fourth via 112b of the second cell. Similarly, the proximity along the Y-direction between third via 112a and fourth via 112b and between first metal layer 110a and second metal layer 110b necessitates a minimum separation between cells along the Y-direction. This dead space between cells adds up across the array of cells and reduces the total number of cells and transistor devices that can be implemented on a given die.

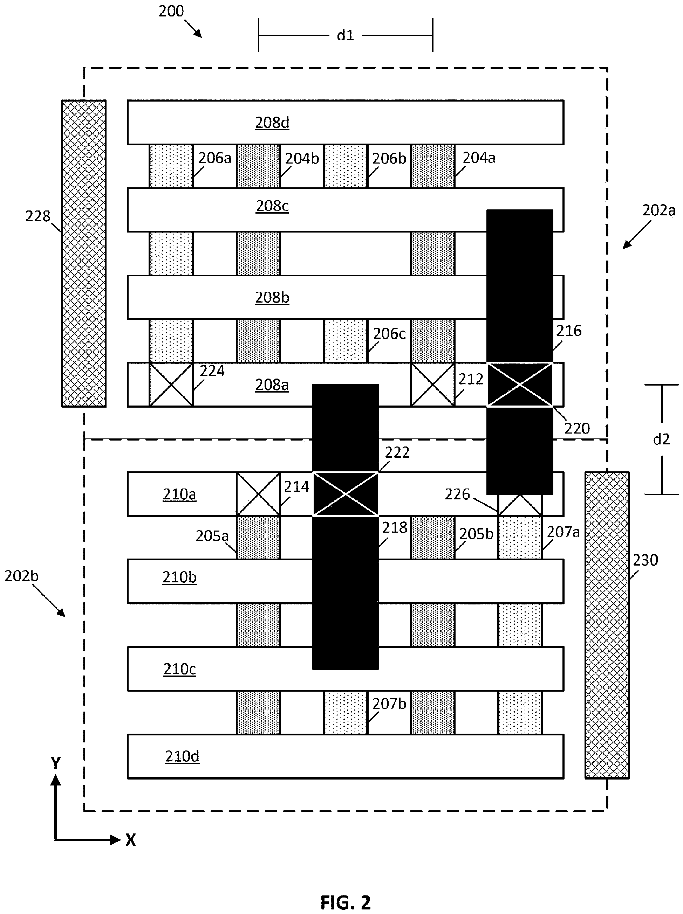

Figure 2 is a plan view of an integrated circuit structure 200 that includes two adjacent cells having reduced dead space between them, according to an embodiment of the present disclosure. As noted above, each cell includes similar transistor structures. Generally, transistor structures may be mirrored or otherwise substantially the same between adjacent cells. Accordingly, a first cell 202a includes a first gate structure 204a and a second gate structure 204b that extend lengthwise along a first direction (e.g., along the Y-direction), and a second cell 202b includes a third gate structure 205a and a fourth gate structure 205b that extend lengthwise along a first direction (e.g., along the Y-direction). Each cell may also include various diffusion contacts that contact source or drain regions for the transistors, such as first diffusion contact 206a, second diffusion contact 206b, and third diffusion contact 206c of first cell 202a, and fourth diffusion contact 207a and fifth diffusion contact 207b of second cell 202b (a sixth diffusion contact of second cell 202b may also be present beneath the metal layer 218). The diffusion contacts may also extend lengthwise along the first direction between adjacent gate structures.

According to some embodiments, first cell 202a and second cell 202b each include a plurality of metal layers that act as signal lines extending over the transistor structures to route signals to/from the transistor structures. For example, first cell 202a includes four metal layers 208a - 208d that extend along a second direction different from the first direction (e.g., orthogonal to the first direction along the X-axis) and second cell 202b includes four metal layers 210a - 210d that extend along the second direction. In this example arrangement, none of the metal layers 208/210 extend on or over the cell boundaries that extend along the second direction. In some examples, only three metal layers are arranged over first cell 202a and three metal layers are arranged over second cell 202b. Metal layers 208a - 208d and 210a - 210d may be equally spaced from one another in the first direction.

According to some embodiments, a first via 212 extends in a third direction (e.g., along a Z-direction into and out of the page) between first gate structure 204a and a first metal layer 208a of first cell 202a. First metal layer 208a may run along the second direction adjacent to the cell boundary between first cell 202a and second cell 202b. According to some embodiments, a second via 214 extends in the third direction between third gate structure 205a and a second metal layer 210a of second cell 202b. Second metal layer 210a may run along the second direction adjacent to the cell boundary between first cell 202a and second cell 202b. According to some embodiments, first via 212 and second via 214 are staggered across the cell boundary such that no portion of first via 212 overlaps with any portion of second via 214 along the first direction. In some embodiments, a distance d1 between a center of first via 212 to a center of second via 214 along the second direction is between about 34 nm and about 50 nm. This distance may be dictated by the process technology used and the width of the gate structures.

According to some embodiments, staggering first via 212 and second via 214 allows for the removal of dead space between first cell 202 and second cell 202b that yields a decrease in the height of each cell. For example, a distance d2 between the center of first via 212 to the center of second via 214 along the first direction may be less than about 40 nm, less than 30 nm, or less than 20 nm. In some examples, d2 is between about 16 nm and about 36 nm.

Other vias may be similarly staggered across the cell boundary between adjacent first cell 202a and second cell 202b. According to some embodiments, a first upper metal layer 216 may extend lengthwise along the first direction and above metal layers 208a - 208d of first cell 202a, and a second upper metal layer 218 may extend lengthwise along the first direction and above metal layers 210a - 210d of second cell 202b. A third via 220 may extend in the third direction between first upper metal layer 216 and first metal layer 208a and a fourth via 222 may extend in the third direction between second upper metal layer 218 and second metal layer 210a. Since third via 220 and fourth via 222 are also coupled to first metal layer 208a and second metal layer 210a, respectively, distance d2 between third via 220 and fourth via 222 is substantially the same as distance d2 between first via 212 and second via 214. In some embodiments, each of first upper metal layer 216 and second upper metal layer 218 may extend in the first direction over the cell boundary between first cell 202a and second cell 202b. In some examples, first upper metal layer 216 may extend over at least a portion of second metal layer 210a, and second upper metal layer 218 may extend over at least a portion of first metal layer 208a.

In some embodiments, vias that contact underlying diffusion contacts may also be staggered across the cell boundary between adjacent first cell 202a and second cell 202b. For example, a fifth via 224 may extend in the third direction between first metal layer 208a and diffusion contact 206a of first cell 202a, and a sixth via 226 may extend in the third direction between second metal layer 210a and diffusion contact 207a of second cell 202b. Since fifth via 224 and sixth via 226 are also coupled to first metal layer 208a and second metal layer 210a, respectively, distance d2 between fifth via 224 and sixth via 226 is substantially the same as distance d2 between first via 212 and second via 214 or between third via 220 and fourth via 222.

In some embodiments, cell boundaries of first cell 202a and second cell 202b that extend along the first direction may include isolation structures, such as a first isolation structure 228 of first cell 202a and a second isolation structure 230 of second cell 202b. Isolation structures 228/230 may include a dielectric material, such as silicon dioxide, filled within a gate trench to isolate cells along the second direction. In some other examples, isolation structures 228/230 can include dummy gate structures that do not take part in the circuit.

It should be understood that the various cell elements illustrated in Figure 2 are not intended to be drawn to scale and that certain structures are not shown for clarity. First cell 202a and second cell 202b represent two cells of any number of cells arranged in an array having any number of rows and columns of cells.

### Fabrication Methodology

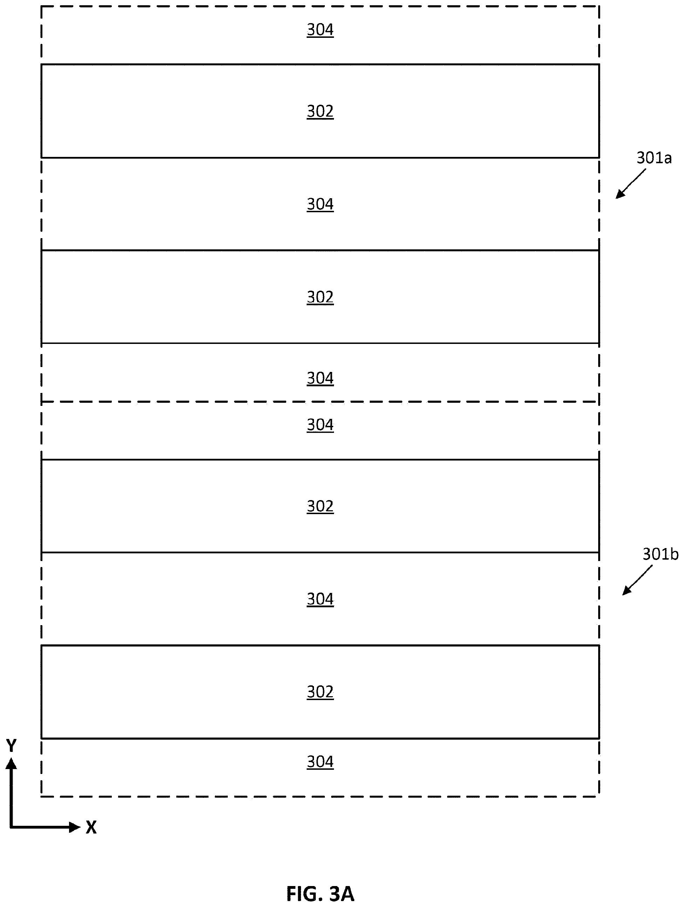

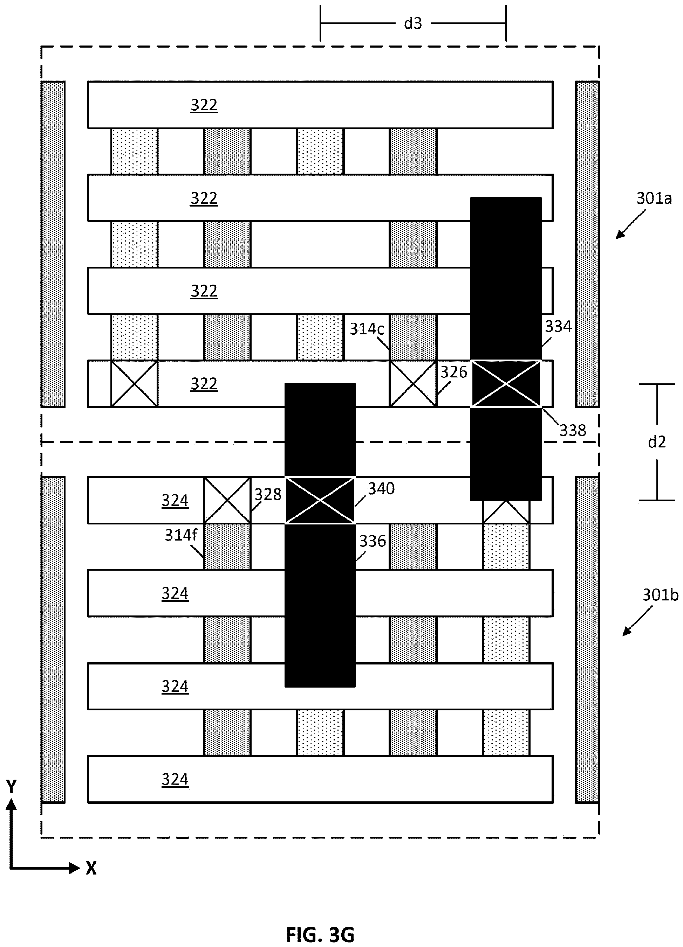

Figures 3A - 3G include plan views that collectively illustrate an example process for forming an integrated circuit with cells having a staggered via arrangement, in accordance with an embodiment of the present disclosure. Each figure shows an example structure that results from the process flow up to that point in time, so the depicted structure evolves as the process flow continues, culminating in the structure shown in Figure 3G, which is similar to the structure shown in Figure 2. The illustrated integrated circuit structure may be part of a larger integrated circuit that includes other cells and/or integrated circuitry not depicted. Example materials and process parameters are given, but the present disclosure is not intended to be limited to any specific such materials or parameters, as will be appreciated.

Figure 3A illustrates a plan view of a first cell 301a adjacent to a second cell 301b. In this early stage of the fabrication process, rows of semiconductor fins 302 extend lengthwise along the second direction (e.g., X-direction) and also extend along the third direction (e.g., Z-direction) above a dielectric layer 304 that runs adjacent and parallel to semiconductor fins 302, according to some embodiments. Semiconductor fins 302 may be a same semiconductor material as the semiconductor substrate (e.g., silicon). In some embodiments, semiconductor fins 302 include alternating layers of different semiconductor materials that are used to form gate-all-around (GAA) structures. For example, semiconductor fins 302 may include sacrificial layers alternating with semiconductor layers. According to some embodiments, the sacrificial layers have a different material composition than the semiconductor layers. In some embodiments, the sacrificial layers are silicon germanium (SiGe) while the semiconductor layers include a semiconductor material suitable for use as a nanoribbon such as silicon (Si), SiGe, germanium, or III-V materials like indium phosphide (InP) or gallium arsenide (GaAs). In examples where SiGe is used in each of the sacrificial layers and in the semiconductor layers, the germanium concentration is different between the sacrificial layers and the semiconductor layers. For example, the sacrificial layers may include a higher germanium content compared to the semiconductor layers.

Dielectric layer 304 may be provided to provide shallow trench isolation (STI) between adjacent semiconductor fins 302. Dielectric layer 304 may be any suitable dielectric material such as silicon dioxide. Note that dielectric layer 304 may align directly over cell boundaries along the second direction.

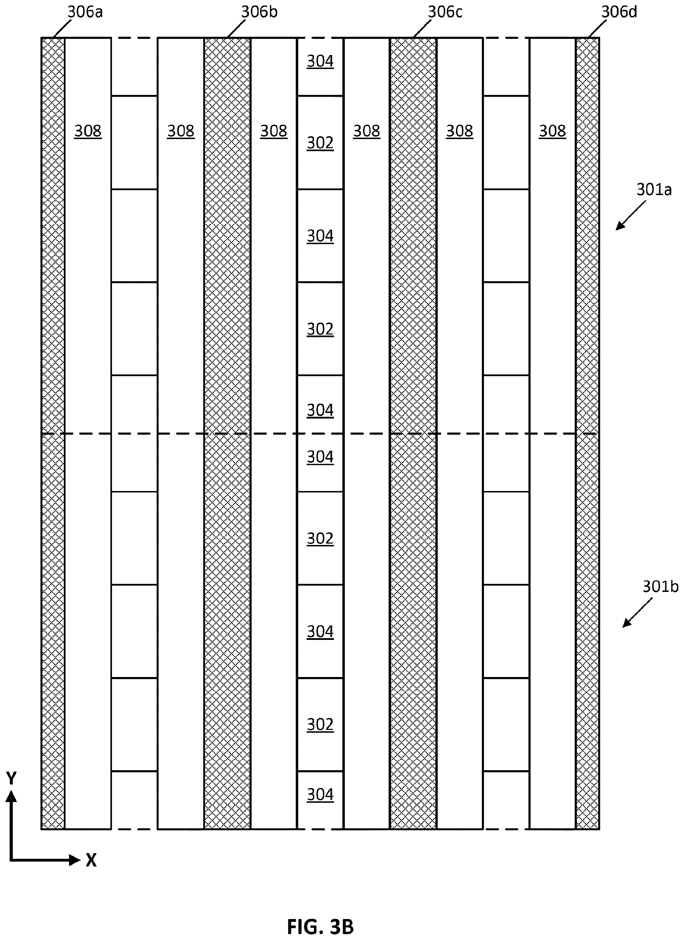

Figure 3B illustrates the plan view of the structure shown in Figure 3A following the formation of sacrificial gates 306a - 306d and spacer structures 308, according to some embodiments. Gate masking layers may first be patterned in strips that extend parallel to one another in the first direction in order to form corresponding sacrificial gates 306a- 306d in respective strips beneath the gate masking layers. Afterwards, the gate masking layers may be removed or may remain as a cap layer above sacrificial gates 306a- 306d. According to some embodiments, the sacrificial gate material is removed in all areas not protected by the gate masking layers. Sacrificial gates 306a - 306d may be any suitable material that can be selectively removed without damaging the semiconductor material of the fins. In some examples, sacrificial gates 306a - 306d includes polysilicon.

According to some embodiments, spacer structures 308 are formed along the sidewalls of sacrificial gates 306a- 306d. Spacer structures 308 may be deposited and then etched back such that spacer structures 308 remain mostly only on sidewalls of any exposed structures. Spacer structures 308 may also be formed along sidewalls of the exposed fins 302 over dielectric layer 304. Such sidewall spacers on the fins can be removed during later processing when forming the source or drain regions. According to some embodiments, spacer structures 308 may be any suitable dielectric material, such as silicon nitride, silicon carbon nitride, or silicon oxycarbonitride. In one such embodiment, spacer structures 308 comprise a nitride and dielectric layer 304 comprises an oxide, so as to provide a degree of etch selectivity during final gate processing. Other etch selective dielectric schemes (e.g., oxide/carbide, carbide/nitride) can be used as well for spacer structures 308 and dielectric layer 304. In other embodiments, spacer structures 308 and dielectric layer 304 are compositionally the same or otherwise similar, where etch selectivity is not employed. In some embodiments, spacer structures 308 have a thinner width compared to sacrificial gates 306a- 306d (along the second direction).

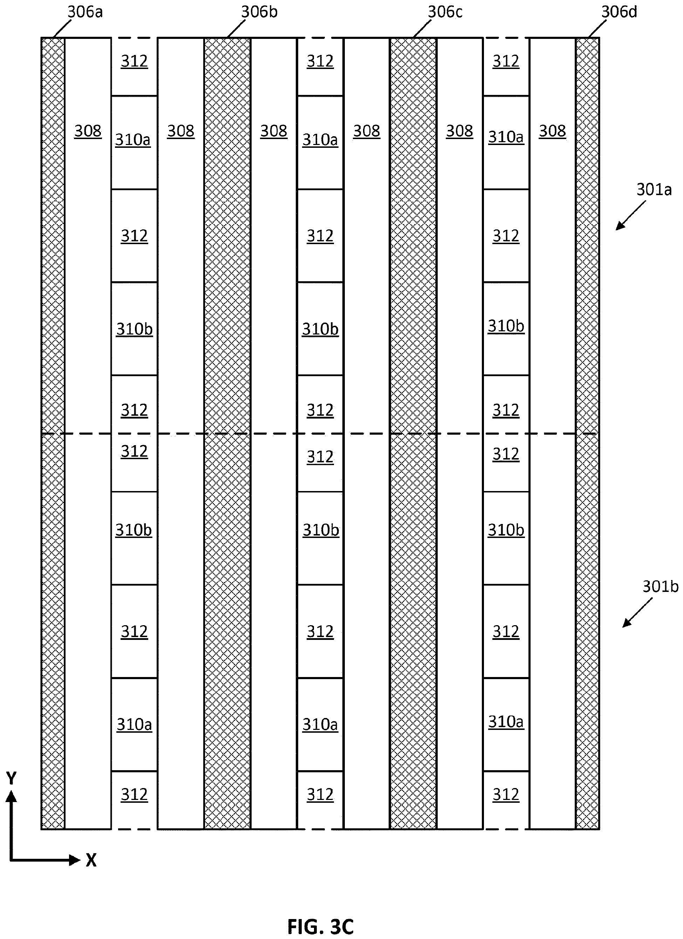

Figure 3C illustrates the plan view of the structure shown in Figure 3B following the removal of the exposed semiconductor fins 302 and subsequent formation of source or drain regions 310a/310b in the regions where the fins were removed, according to some embodiments. The exposed fin portions may be removed using any anisotropic etching process, such as reactive ion etching (RIE). The removal of the exposed fin portions creates source or drain trenches that alternate with gate trenches (currently filled with sacrificial gates 306a - 306d) along the second direction (with spacer structures 308 in-between), according to some embodiments.

According to some embodiments, each cell includes one or more first source or drain regions 310a and one or more second source or drain regions 310b. First source or drain regions 310a may be aligned together along the second direction, and second source or drain regions 310b may be aligned together along the second direction. According to some embodiments, first source or drain regions 310a and second source or drain regions 310b are epitaxially grown from the exposed semiconductor material at the ends of the semiconductor layers or fin at the edges of spacer structures 308. In some example embodiments, first source or drain regions 310a are NMOS source or drain regions (e.g., epitaxial silicon) and second source or drain regions 310b are PMOS source or drain regions (e.g., epitaxial SiGe), or vice-versa. Dopants such as phosphorous or boron may also be added to the NMOS source or drain regions or PMOS source or drain regions, respectively.

According to some embodiments, a dielectric fill 312 is provided between adjacent source or drain regions 310a and 310b along the source/drain trenches. In some examples, dielectric fill 312 occupies a remaining volume within the source/drain trench around and over source or drain regions 310a and 310b. Dielectric fill 312 may be any suitable dielectric material, such as silicon dioxide. In some examples, dielectric fill 312 extends up to and planar with a top surface of spacer structures 308 (e.g., following a polishing procedure).

The semiconductor fins (or at least semiconductor layers) extend between each adjacent pair of first source or drain regions 310a and between each adjacent pair of second source or drain regions 310b along the second direction beneath corresponding sacrificial gates 306a- 306d and spacer structures 308. Accordingly, a single transistor may be formed between each adjacent pair of source or drain regions 310a/310b along the second direction. According to some embodiments, each of first cell 301a and second cell 301b has four transistors, with two NMOS transistors and two PMOS transistors.

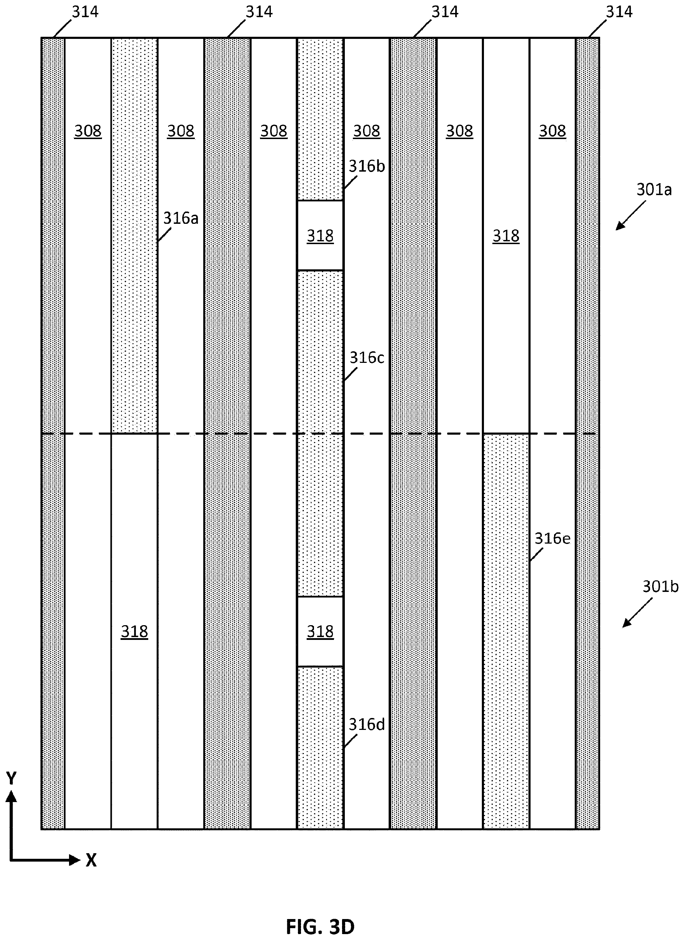

Figure 3D illustrates the plan view of the structure shown in Figure 3C following the formation of gate structures and diffusion contacts, according to some embodiments. Sacrificial gates 306a - 306d may be removed using any suitable isotropic etching process and replaced with gate structures 314. In the example where the fins include alternating semiconductor layers, the sacrificial layers are selectively removed to leave behind the semiconductor layers as nanoribbons that extend between corresponding source or drain regions. Sacrificial gates 306a - 306d and the sacrificial layers may be removed using the same isotropic etching process or different isotropic etching processes. Any number of nanoribbons may be used per transistor, such as three nanoribbons, or four nanoribbons, to name a few examples.

Each of gate structures 314 may include a gate dielectric over the semiconductor nanoribbons or semiconductor body within the gate trenches, and a gate electrode that fills a remainder of the gate trenches. The gate dielectric may include any suitable dielectric material (such as silicon dioxide, and/or a high-k dielectric material). The gate electrodes may include one or more conductive layers that can be deposited using electroplating, electroless plating, CVD, PECVD, ALD, or PVD, to name a few examples. The gate electrodes can include any suitable metals or metal alloys such as aluminum, tungsten, cobalt, molybdenum, ruthenium, titanium, tantalum, copper, and carbides and nitrides thereof.

According to some embodiments, various diffusion contacts 316a - 316e may be formed within the source/drain trenches to contact underlying source or drain regions. Any portions of the source/drain trenches that do not include diffusion contacts may include another dielectric fill 318, which may be similar to dielectric fill 312. In some embodiments, dielectric fill 318 represents portions of dielectric fill 312 that remain behind following the formation of diffusion contacts 316a - 316e. According to some embodiments, diffusion contacts 316a - 316e may include any suitable conductive material, such as tungsten, ruthenium, or molybdenum.

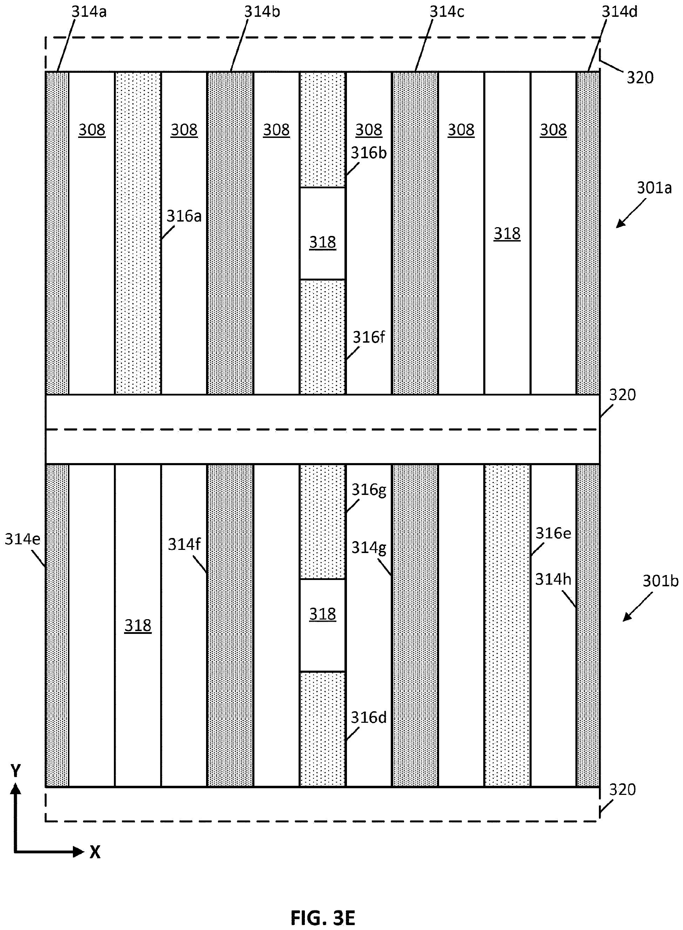

Figure 3E illustrates the plan view of the structure shown in Figure 3D following the formation of gate cuts 320, according to some embodiments. Gate cuts 320 extend lengthwise along the second direction to cut across any number of gate structures 314. Accordingly, the central gate cut 320 separates gate structures 314 into a first set of gate structures 314a - 314d of first cell 301a and a second set of gate structures 314e - 314h of second cell 301b. In some examples, gate cuts 320 are aligned with the cell boundaries, such that the cell boundaries along the second direction define a central line of the gate cuts 320. Accordingly, the spacing of gate cuts 320 may define the height of first cell 301a and the height of second cell 301b. Gate cuts 320 may extend in the third direction through at least an entire thickness of gate structures 314a - 314h. Gate cuts 320 may include any number of suitable dielectric materials, such as silicon oxide, silicon nitride, or silicon carbide.

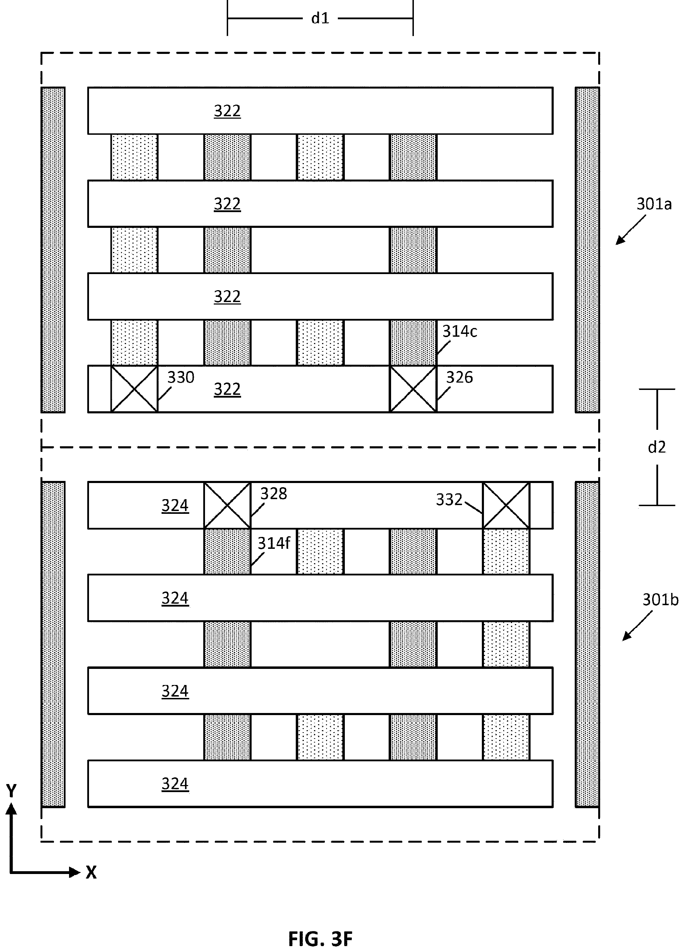

Figure 3F illustrates the plan view of the structure shown in Figure 3E following the formation of signal lines and various vias across first and second cells 301a and 301b, according to some embodiments. Note that the various dielectric materials are not shown for clarity. Accordingly, dielectric fill 318, spacer structures 308, and gate cuts 320 are not illustrated in this view.

Any number of first metal layers 322 may be formed over the transistor structures of first cell 301a and any number of second metal layers 324 may be formed over the transistor structures of second cell 301b. In the illustrated example, four equally spaced first metal layers 322 extend along the second direction, and four equally spaced second metal layers 324 extend along the second direction. In this example arrangement, none of first metal layers 322 or second metal layers 324 extend on or over the cell boundaries that extend along the second direction. First and second metal layers 322/324 may include any suitable conductive material, such as copper, tungsten, ruthenium, or molybdenum.

According to some embodiments, a first via 326 is formed between a first metal layer 322 adjacent to a cell boundary and an underlying gate structure 314c, and a second via 328 is formed between a second metal layer 324 adjacent to the cell boundary and an underlying gate structure 314f. Each of first via 326 and second via 328 extend in the third direction and may be substantially the same size and material composition. First via 326 and second via 328 can include any suitable conductive material such as copper, tungsten, ruthenium, or molybdenum.

According to some embodiments, first via 326 and second via 328 are staggered across the cell boundary such that no portion of first via 326 overlaps with any portion of second via 328 along the first direction. In some embodiments, a distance d1 between a center of first via 326 to a center of second via 326 along the second direction is between about 34 nm and about 50 nm.

According to some embodiments, staggering first via 326 and second via 328 allows for the removal of dead space between first cell 301a and second cell 301b that yields a decrease in the height of each cell. For example, a distance d2 between the center of first via 326 to the center of second via 328 along the first direction may be less than about 40 nm, less than 30 nm, or less than 20 nm. In some examples, d2 is between about 16 nm and about 36 nm. In some embodiments, distance d2 may be reduced to be substantially the same as the pitch between adjacent first metal layers 322 and/or the pitch between adjacent second metal layers 324.

According to some embodiments, a third via 330 is formed between first metal layer 322 adjacent to the cell boundary and underlying diffusion contact 316a, and a fourth via 332 is formed between second metal layer 324 adjacent to the cell boundary and underlying diffusion contact 316e. Each of third via 330 and fourth via 332 extend in the third direction and may be substantially the same size and material composition. Third via 330 and fourth via 332 can include any suitable conductive material such as copper, tungsten, ruthenium, or molybdenum.

According to some embodiments, third via 330 and fourth via 332 may be similarly staggered across the cell boundary such that no portion of third via 330 overlaps with any portion of fourth via 332 along the first direction. Since third via 330 and fourth via 332 are aligned over the same first metal layer 322 and second metal layer 324 as first via 326 and second via 328, respectively, third via 330 and fourth via 332 have substantially the same distance d2 between their centers along the first direction.

Figure 3G illustrates the plan view of the structure shown in Figure 3F following the formation of additional signal lines (e.g., higher metal layers) and another set of vias to the additional signal lines, according to some embodiments. A third metal layer 334 may be formed that extends lengthwise along the first direction over one or more of first metal layers 322, and a fourth metal layer 336 may be formed the extends lengthwise along the first direction over one or more of second metal layers 324. Each of third metal layer 334 and fourth metal layer 336 may include any suitable conductive material, such as copper, tungsten, ruthenium, or molybdenum. In some embodiments, third metal layer 334 extends across the cell boundary between first cell 301a and second cell 301b and/or fourth metal layer 336 extends across the cell boundary between first cell 301a and second cell 301b. Accordingly, third metal layer 334 and/or fourth metal layer 336 may extend across an entire width (e.g., along the first direction) of gate cut 320 between first cell 301a and second cell 301b. In some embodiments, third metal layer 334 extends over at least a portion of one or more of second metal layers 324 and/or fourth metal layer 336 extends over at least a portion of one or more of first metal layers 322.

According to some embodiments, a fifth via 338 is formed between first metal layer 322 adjacent to the cell boundary and third metal layer 334, and a sixth via 340 is formed between second metal layer 324 adjacent to the cell boundary and fourth metal layer 336. Each of fifth via 338 and sixth via 340 extend in the third direction and may be substantially the same size and material composition. Fifth via 338 and sixth via 340 can include any suitable conductive material such as copper, tungsten, ruthenium, or molybdenum.

According to some embodiments, fifth via 338 and sixth via 340 may be similarly staggered across the cell boundary such that no portion of fifth via 338 overlaps with any portion of sixth via 340 along the first direction. In some embodiments, a distance d3 between a center of fifth via 338 to a center of sixth via 340 along the second direction is between about 34 nm and about 50 nm. The distance d3 between the center of fifth via 338 to the center of sixth via 340 may extend as wide as the cell width of first cell 301a or second cell 301b, such that fifth via 338 and sixth via 340 may be located anywhere along first metal layer 322 and second metal layer 324, respectively. Since fifth via 338 and sixth via 340 are aligned over the same first metal layer 322 and second metal layer 324 as first via 326 and second via 328, respectively, fifth via 338 and sixth via 340 have substantially the same distance d2 between their centers along the first direction.

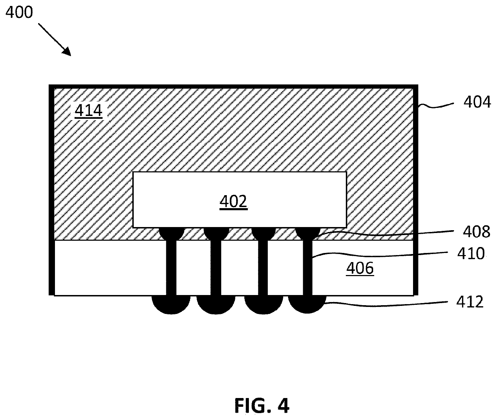

Figure 4 illustrates an example embodiment of a chip package 400, in accordance with an embodiment of the present disclosure. As can be seen, chip package 400 includes one or more dies 402. One or more dies 402 may include at least one integrated circuit having semiconductor devices, such as any of the semiconductor devices without a layout arrangement disclosed herein. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Methodology

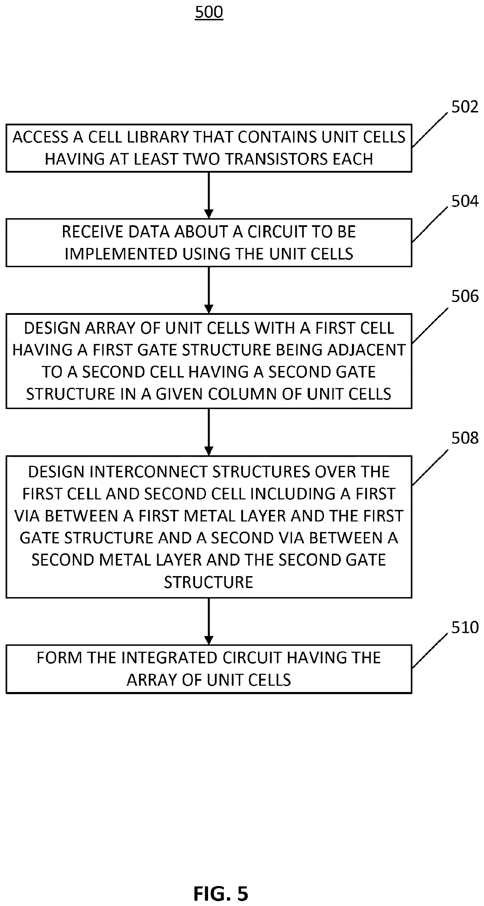

Figure 5 illustrates a flowchart depicting a method 500 of designing and forming the integrated circuit structure of Figure 2, in accordance with an embodiment of the present disclosure.

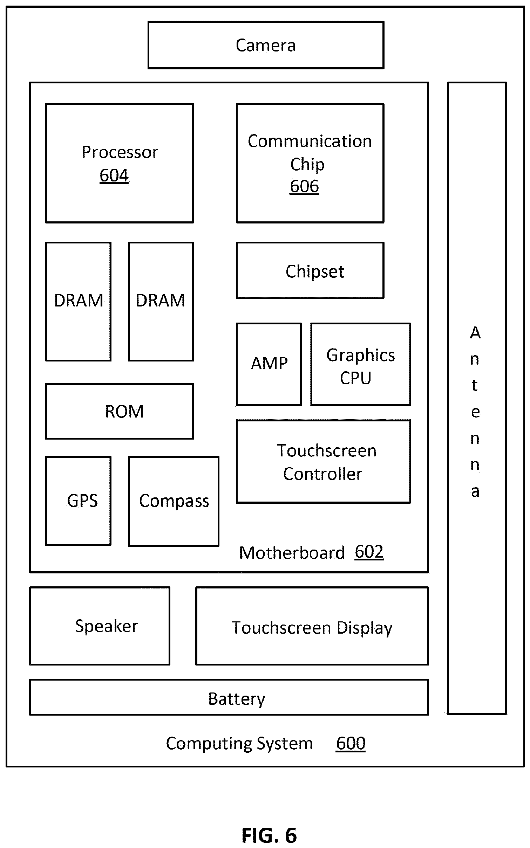

In an example, a hardware computer may be used to implement one or more operations of method 500, such as operations 502, 504, 506, and/or 508. The hardware computer may include a hardware processor communicatively coupled to a non-transitory, computer readable storage medium that includes a set of executable instructions, when executed, can perform one or more design operations of method 500. The hardware processor may execute the instructions within the computer readable storage medium, to perform the operations 502, 504, 506, and/or 508 of method 500. In an example, the hardware processor is a central processing unit (CPU), a graphic processing unit (GPU), a distributed processing system, an application specific integrated circuit (ASIC), and/or another appropriate processor. In an example, the computer readable storage medium is an appropriate storage medium, such as a volatile memory (e.g., DRAM), non-volatile memory (e.g., ROM), a mass storage device (such as hard disk drive, compact disk (CD), digital versatile disk (DVD), and so forth). Examples of the hardware processor and the computer readable storage medium have been discussed herein with respect to Figure 6.

Method 500 includes operation 502 where a cell library is accessed that has unit cells with at least two transistors in each unit cell. An appropriate integrated circuit design tool, such as an EDA (Electronic design automation) tool being executed in the hardware computer, may be used for forming and/or accessing the cell library and for subsequent design processes. In some examples, each unit cell is substantially the same (e.g., having the same width, height, and number of transistors).

Method 500 continues with operation 504 where data about a circuit to be implemented using the cells is received (e.g., by the hardware computer).

Method 500 continues with operation 506 where an integrated circuit structure having an array of unit cells is designed. The unit cells may be arranged in an array of adjacent rows and columns. It should be understood that the array may also include space between any two adjacent cells. Each of the unit cells of the array may include substantially the same arrangement of transistor structures (e.g., two transistors, four transistors, or six transistors per unit cell). In an embodiment, a first cell is adjacent to a second cell in a given column with the first cell including at first gate structure and the second cell including a second gate structure. Each of the first and second gate structures may extend along the height direction of the cells.

Method 500 continues with operation 508 where any number of interconnect structures are designed for the integrated circuit structure with the designed array of unit cells. The interconnect structures may include any number of metal layers and vias across any number of stacked dielectric layers above the transistor structures. The interconnect structures may be used to route logic signals, power signals, and ground signals to any of the transistors across any of the cells in the array.

According to some embodiments, the interconnect structures include a first via connected between the first gate structure and a first metal layer in an interconnect layer above the transistors and a second via between the second gate structure and a second metal layer in the interconnect layer (or a different interconnect layer) above the transistors. According to some embodiments, the first and second metal layers extend parallel and adjacent to a cell boundary between the first and second cells and on opposite sides of the cell boundary. According to some embodiments, the first and second vias are staggered such that no part of the first via overlaps with any part of the second via along the cell height direction. For example, a distance between the center of the first via to a center of the second via along the cell height direction may be less than about 40 nm, less than 30 nm, or less than 20 nm. In some examples, the distance is between about 16 nm and about 36 nm.

The method 500 then proceeds to operation 510 where the integrated circuit having the array of unit cells and interconnect structures is formed. According to some embodiments, the integrated circuit may be formed using any of the techniques described with reference to Figures 3A - 3G.

Note that the operations in method 500 are shown in a particular order for ease of description. However, one or more of the processes may be performed in a different order or may not be performed at all (and thus be optional), in accordance with some embodiments. Numerous variations on method 500 and the techniques described herein will be apparent in light of this disclosure.

### Example System

Figure 6 illustrates a computing system 600 implemented with any number of integrated circuit structures (such as the integrated circuit structure illustrated in Figure 2) discussed herein and/or used to implement the design processes discussed with respect to the method 500 of Figure 5, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board, whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices formed using the disclosed techniques in accordance with an example embodiment. In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more integrated circuit structures or devices formed using the disclosed techniques as variously described herein. As will be appreciated in light of this disclosure, note that multistandard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following examples pertain to further embodiments, from which numerous permutations and configurations will be apparent.

Example 1 is an integrated circuit structure that includes a first cell having two or more first transistor devices with the two or more first transistor devices comprising a first gate structure extending along a first direction within the first cell and a second cell adjacent to the first cell in the first direction. The second cell has two or more second transistor devices with the two or more second transistor devices comprising a second gate structure extending along the first direction within the second cell. The integrated circuit structure further includes a first metal layer extending along a second direction different from the first direction and above the first gate structure, a second metal layer extending along the second direction and above the second gate structure, a first via extending in a third direction between the first metal layer and the underlying first gate structure, and a second via extending in the third direction between the second metal layer and the underlying second gate structure. No part of the second via overlaps with any part of the first via along the first direction.

Example 2 includes the integrated circuit structure of Example 1, further comprising a third metal layer extending along the first direction and above the first metal layer, a fourth metal layer extending along the first direction and above the second metal layer, a third via extending in the third direction between the third metal layer and the first metal layer, and a fourth via extending in the third direction between the fourth metal layer and the second metal layer. No part of the fourth via overlaps with any part of the third via along the first direction.

Example 3 includes the integrated circuit structure of Example 2, wherein the third metal layer extends along the first direction over at least a portion of the second metal layer, and wherein the fourth metal layer extends along the first direction over at least a portion of the first metal layer.

Example 4 includes the integrated circuit structure of Example 2 or 3, further comprising a gate cut extending in the second direction between the first gate structure and the second gate structure.

Example 5 includes the integrated circuit structure of Example 4, wherein a boundary between the first cell and the second cell extends along the gate cut in the second direction.

Example 6 includes the integrated circuit structure of Example 4 or 5, wherein the third metal layer extends over an entire width of the gate cut in the first direction, and wherein the fourth metal layer extends over the entire width of the gate cut in the first direction.

Example 7 includes the integrated circuit structure of any one of Examples 4-6, wherein the first via is aligned adjacent to a first side of the gate cut and the second via is aligned adjacent to a second side of the gate cut, the second side being opposite to the first side along the first direction.

Example 8 includes the integrated circuit structure of any one of Examples 1-7, wherein the first direction is orthogonal to the second direction, and the third direction is orthogonal to both the first and second directions.

Example 9 includes the integrated circuit structure of any one of Examples 1-8, wherein a distance along the first direction between a center of the first via and a center of the second via is between about 16 nm and about 36 nm.

Example 10 is an integrated circuit designing system that includes at least one processor, a non-transitory storage medium storing instructions that, when executed by the at least one processor, cause the system to perform a method. The method includes accessing a cell library having unit cells, wherein each unit cell has corresponding two or more transistor devices, receiving data about a circuit to be implemented using the unit cells, designing an array containing rows and columns of unit cells to implement the circuit, and designing a plurality of interconnect structures to implement the circuit. A column of unit cells includes a first unit cell and a second unit cell directly adjacent to the first unit cell. The first unit cell comprises a first gate structure extending along a first direction within the first unit cell and the second unit cell comprises a second gate structure extending along the first direction within the second unit cell. The plurality of interconnect structures include a first metal layer extending along a second direction different from the first direction and above the first gate structure, a second metal layer extending along the second direction and above the second gate structure, a first via extending in a third direction between the first metal layer and the underlying first gate structure, and a second via extending in the third direction between the second metal layer and the underlying second gate structure. No part of the second via overlaps with any part of the first via along the first direction.

Example 11 includes the integrated circuit designing system of Example 10, wherein the interconnect structures further comprise a third metal layer extending along the first direction and above the first metal layer, a fourth metal layer extending along the first direction and above the second metal layer, a third via extending in the third direction between the third metal layer and the first metal layer, and a fourth via extending in the third direction between the fourth metal layer and the second metal layer. No part of the fourth via overlaps with any part of the third via along the first direction.

Example 12 includes the integrated circuit designing system of Example 11, wherein the third metal layer extends along the first direction over at least a portion of the second metal layer, and wherein the fourth metal layer extends along the first direction over at least a portion of the first metal layer.

Example 13 includes the integrated circuit designing system of Example 11 or 12, wherein designing the array further comprises including a gate cut extending in the second direction between the first gate structure and the second gate structure.

Example 14 includes the integrated circuit designing system of Example 13, wherein a boundary between the first unit cell and the second unit cell extends along the gate cut in the second direction.

Example 15 includes the integrated circuit designing system of Example 13 or 14, wherein the third metal layer extends over an entire width of the gate cut in the first direction, and wherein the fourth metal layer extends over the entire width of the gate cut in the first direction.

Example 16 includes the integrated circuit designing system of any one of Examples 13-15, wherein the first via is aligned adjacent to a first side of the gate cut and the second via is aligned adjacent to a second side of the gate cut, the second side being opposite to the first side along the first direction.

Example 17 includes the integrated circuit designing system of any one of Examples 10-16, wherein the first direction is orthogonal to the second direction, and the third direction is orthogonal to both the first and second directions.

Example 18 is an integrated circuit structure that includes a first transistor device, a second transistor device, a first via, and a second via. The first transistor device includes a first source region, a first drain region, a first body comprising semiconductor material extending from the first source region to the first drain region, and a first gate structure extending over the first body. The first gate structure extends in a first direction over the first body and the first body extends from the first source region to the first drain region in a second direction different from the first direction. The second transistor device is spaced from the first transistor device along the first direction and along the second direction. The second transistor device includes a second source region, a second drain region, a second body comprising semiconductor material extending from the second source region to the second drain region in the second direction, and a second gate structure extending over the second body in the first direction. The first via is coupled to the first gate structure and extends in a third direction above the first gate structure. The second via is couped to the second gate structure and extends in a third direction above the second gate structure. A distance between a center of the first via and a center of the second via along the first direction is less than 40 nm.

Example 19 includes the integrated circuit structure of Example 18, wherein the first body comprises one or more first semiconductor nanoribbons and the second body comprises one or more second semiconductor nanoribbons.

Example 20 includes the integrated circuit structure of Example 19, wherein the one or more first semiconductor nanoribbons and the one or more second semiconductor nanoribbons comprise germanium, silicon, or any combination thereof.

Example 21 includes the integrated circuit structure of any one of Examples 18-20, wherein no part of the second via overlaps with any part of the first via along the first direction.

Example 22 includes the integrated circuit structure of any one of Examples 18-21, further comprising a first metal layer extending along the second direction and above the first gate structure such that the first via extends from the first metal layer to the first gate structure, and a second metal layer extending along the second direction and above the second gate structure such that the second via extends from the second metal layer to the second gate structure.

Example 23 includes the integrated circuit structure of Example 22, further comprising a third metal layer extending along the first direction and above the first metal layer, a fourth metal layer extending along the first direction and above the second metal layer, a third via extending in the third direction between the third metal layer and the first metal layer, and a fourth via extending in the third direction between the fourth metal layer and the second metal layer. A distance between a center of the third via and a center of the fourth via along the first direction is less than 40 nm.

Example 24 includes the integrated circuit structure of Example 23, wherein no part of the third via overlaps with any part of the fourth via along the first direction.

Example 25 includes the integrated circuit structure of Example 23 or 24, wherein the third metal layer extends along the first direction over at least a portion of the second metal layer, and wherein the fourth metal layer extends along the first direction over at least a portion of the first metal layer.

Example 26 includes the integrated circuit structure of any one of Examples 18-25, further comprising a gate cut extending in the second direction between the first transistor device and the second transistor device.

Example 27 includes the integrated circuit structure of Example 26, wherein the first transistor device is one transistor device of a first unit cell and the second transistor device is one transistor device of a second unit cell, wherein a boundary between the first unit cell and the second unit cell extends along the gate cut in the second direction.

Example 28 includes the integrated circuit structure of Example 26 or 27, wherein the first via is aligned adjacent to a first side of the gate cut and the second via is aligned adjacent to a second side of the gate cut, the second side being opposite to the first side along the first direction.

Example 29 includes the integrated circuit structure of any one of Examples 18-28, wherein the first direction is orthogonal to the second direction, and the third direction is orthogonal to both the first and second directions.

Example 30 includes the integrated circuit structure of any one of Examples 18-29, wherein the distance between the center of the first via and the center of the second via along the first direction is between about 16 nm and about 36 nm.

Example 31 is an integrated circuit structure that includes a first cell having two or more first transistor devices with the two or more first transistor devices comprising a first gate structure extending along a first direction within the first cell and a first contact on a first source or drain region adj acent to the first gate structure, and a second cell adjacent to the first cell in the first direction. The second cell has two or more second transistor devices with the two or more second transistor devices comprising a second gate structure extending along the first direction within the second cell and a second contact on a second source or drain region adjacent to the second gate structure. The integrated circuit structure further includes a first metal layer extending along a second direction different from the first direction and above the first contact, a second metal layer extending along the second direction and above the second contact, a first via extending in a third direction between the first metal layer and the underlying first contact, and a second via extending in the third direction between the second metal layer and the underlying second contact. No part of the second via overlaps with any part of the first via along the first direction.

Example 32 includes the integrated circuit structure of Example 31, further comprising a third metal layer extending along the first direction and above the first metal layer, a fourth metal layer extending along the first direction and above the second metal layer, a third via extending in the third direction between the third metal layer and the first metal layer, and a fourth via extending in the third direction between the fourth metal layer and the second metal layer. No part of the fourth via overlaps with any part of the third via along the first direction.

Example 33 includes the integrated circuit structure of Example 32, wherein the third metal layer extends along the first direction over at least a portion of the second metal layer, and wherein the fourth metal layer extends along the first direction over at least a portion of the first metal layer.

Example 34 includes the integrated circuit structure of Example 32 or 33, further comprising a gate cut extending in the second direction between the first gate structure and the second gate structure.

Example 35 includes the integrated circuit structure of Example 34, wherein a boundary between the first cell and the second cell extends along the gate cut in the second direction.

Example 36 includes the integrated circuit structure of Example 34 or 35, wherein the third metal layer extends over an entire width of the gate cut in the first direction, and wherein the fourth metal layer extends over the entire width of the gate cut in the first direction.

Example 37 includes the integrated circuit structure of any one of Examples 34-36, wherein the first via is aligned adjacent to a first side of the gate cut and the second via is aligned adjacent to a second side of the gate cut, the second side being opposite to the first side along the first direction.

Example 38 includes the integrated circuit structure of any one of Examples 31-37, wherein the first direction is orthogonal to the second direction, and the third direction is orthogonal to both the first and second directions.

Example 39 includes the integrated circuit structure of any one of Examples 31-38, wherein a distance along the first direction between a center of the first via and a center of the second via is between about 16 nm and about 36 nm.

The foregoing description of example embodiments of the present disclosure has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto.

## Claims

1. An integrated circuit structure, comprising:
a first cell having two or more first transistor devices, the two or more first transistor devices comprising a first gate structure extending along a first direction within the first cell;
a second cell adjacent to the first cell in the first direction, the second cell having two or more second transistor devices, the two or more second transistor devices comprising a second gate structure extending along the first direction within the second cell;
a first metal layer extending along a second direction different from the first direction and above the first gate structure;
a second metal layer extending along the second direction and above the second gate structure;
a first via extending in a third direction between the first metal layer and the underlying first gate structure; and
a second via extending in the third direction between the second metal layer and the underlying second gate structure, wherein no part of the second via overlaps with any part of the first via along the first direction.

2. The integrated circuit structure of claim 1, further comprising:
a third metal layer extending along the first direction and above the first metal layer;
a fourth metal layer extending along the first direction and above the second metal layer;
a third via extending in the third direction between the third metal layer and the first metal layer; and
a fourth via extending in the third direction between the fourth metal layer and the second metal layer, wherein no part of the fourth via overlaps with any part of the third via along the first direction.

3. The integrated circuit structure of claim 2, wherein the third metal layer extends along the first direction over at least a portion of the second metal layer, and wherein the fourth metal layer extends along the first direction over at least a portion of the first metal layer.

4. The integrated circuit structure of claim 2 or 3, further comprising a gate cut extending in the second direction between the first gate structure and the second gate structure.

5. The integrated circuit structure of claim 4, wherein a boundary between the first cell and the second cell extends along the gate cut in the second direction.

6. The integrated circuit structure of claim 4 or 5, wherein the third metal layer extends over an entire width of the gate cut in the first direction, and wherein the fourth metal layer extends over the entire width of the gate cut in the first direction.

7. The integrated circuit structure of any one of claims 4 through 6, wherein the first via is aligned adjacent to a first side of the gate cut and the second via is aligned adjacent to a second side of the gate cut, the second side being opposite to the first side along the first direction.

8. The integrated circuit structure of any one of claims 1 through 7, wherein the first direction is orthogonal to the second direction, and the third direction is orthogonal to both the first and second directions.

9. The integrated circuit structure of any one of claims 1 through 8, wherein a distance along the first direction between a center of the first via and a center of the second via is between about 16 nm and about 36 nm.

10. An integrated circuit designing system that includes at least one processor, a non-transitory storage medium storing instructions that, when executed by the at least one processor, cause the system to perform a method, the method comprising:
accessing a cell library having unit cells, wherein each unit cell has corresponding two or more transistor devices;
receiving data about a circuit to be implemented using the unit cells;
designing an array containing rows and columns of unit cells to implement the circuit; and
designing a plurality of interconnect structures to implement the circuit;
wherein a column of unit cells includes a first unit cell and a second unit cell directly adjacent to the first unit cell;
wherein the first unit cell comprises a first gate structure extending along a first direction within the first unit cell, and the second unit cell comprises a second gate structure extending along the first direction within the second unit cell; and
wherein the plurality of interconnect structures include
a first metal layer extending along a second direction different from the first direction and above the first gate structure,
a second metal layer extending along the second direction and above the second gate structure,
a first via extending in a third direction between the first metal layer and the underlying first gate structure, and
a second via extending in the third direction between the second metal layer and the underlying second gate structure, wherein no part of the second via overlaps with any part of the first via along the first direction.

11. The integrated circuit designing system of claim 10, wherein the interconnect structures further comprise: a third metal layer extending along the first direction and above the first metal layer; a fourth metal layer extending along the first direction and above the second metal layer; a third via extending in the third direction between the third metal layer and the first metal layer; and a fourth via extending in the third direction between the fourth metal layer and the second metal layer, wherein no part of the fourth via overlaps with any part of the third via along the first direction.

12. The integrated circuit designing system of claim 11, wherein designing the array further comprises including a gate cut extending in the second direction between the first gate structure and the second gate structure.

13. The integrated circuit designing system of claim 12, wherein a boundary between the first unit cell and the second unit cell extends along the gate cut in the second direction.

14. The integrated circuit designing system of claim 12 or 13, wherein the first via is aligned adjacent to a first side of the gate cut and the second via is aligned adjacent to a second side of the gate cut, the second side being opposite to the first side along the first direction.

15. The integrated circuit designing system of any one of claims 10 through 14, wherein the first direction is orthogonal to the second direction, and the third direction is orthogonal to both the first and second directions.
